# EUROPEAN PATENT APPLICATION

(11) **EP 4 667 951 A2**
(43) Date of publication of application: **24.12.2025**
(21) Application number: 25213774.0
(22) Date of filing: 05.11.2025
(51) Int. Cl.: G01R 31/317, G01R 31/3183, G01R 31/3193

(54) **CIRCUIT AND METHOD FOR PERFORMING FUNCTIONAL SAFETY TEST, NEURAL PROCESSING UNIT, AND STORAGE MEDIUM**

(30) Priority: 14.11.2024 CN 202411630270
(71) Applicant: Beijing Horizon Information Technology Co., Ltd., Beijing 100094 (CN)
(72) Inventor: YUAN, Jiawei, Beijing, 100094 (CN); DING, Jinnan, Beijing, 100094 (CN)
(74) Representative: V.O.

(57) **Abstract**

Disclosed are a circuit and method for performing functional safety test, a neural processing unit, and a storage medium, relating to field of functional safety technology. The circuit for performing functional safety test includes: a configurator, configured for generating and outputting configuration information for testing an integrated circuit (IC) to be tested; a plurality of test data generators, configured for generating and outputting, based on the configuration information, a plurality of first test data corresponding respectively to the test data generators; the integrated circuit to be tested, configured for processing the plurality of first test data, to obtain and output a plurality of second test data; and a first comparator, configured for comparing consistency among the plurality of second test data, to obtain a first test result for the integrated circuit to be tested.

## Description

### TECHNICAL FIELD

This disclosure relates to field of integrated circuit (IC) technology, and in particular, to a circuit and method for performing functional safety test, an apparatus, and a storage medium.

### BACKGROUND

At present, functional safety (FuSa) test is performed on an integrated circuit mainly by parity check. When performing FuSa test on the integrated circuit by parity check, a parity bit is to be attached to data transmitted by the IC, to detect a possible fault in a line configured for data transmission using the data transmitted with the parity bit attached. However, by the parity check, it may be detected just whether an abnormality occurs to the line configured for data transmission in the IC, but it fails to detect whether a fault occurs to an operation circuit configured for performing logic operation on the data transmitted by the integrated circuit. Therefore, in case the integrated circuit includes the operation circuit, performing FuSa test by the parity check easily fails to meet an expected FuSa standard. Moreover, when performing FuSa test on the integrated circuit by the parity check, the parity bit is to be attached to the data transmitted, thereby leading to a great area overhead and great data transmission power consumption for the integrated circuit.

### SUMMARY

An existing circuit for performing functional safety test fails to meet an expected FuSa standard, and has great data transmission power consumption, as well as a great circuit area overhead.

To solve the above technical problem, this disclosure provides a circuit for performing functional safety test, including:
a configurator, configured for generating configuration information for testing an integrated circuit (IC) to be tested, and outputting the configuration information;
a plurality of test data generators, coupled to the configurator, and configured for generating and outputting, based on the configuration information, a plurality of first test data corresponding respectively to the test data generators;
the integrated circuit to be tested, coupled to the plurality of test data generators, and configured for processing the plurality of first test data, to obtain and output a plurality of second test data; and
a first comparator, coupled to the integrated circuit to be tested, and configured for comparing consistency among the plurality of second test data, to obtain a first test result for the integrated circuit to be tested.

A second aspect of this disclosure provides a method for performing functional safety test on an integrated circuit, including:
generating, by a configurator, configuration information for testing an integrated circuit (IC) to be tested;
generating, by a plurality of test data generators based on the configuration information, a plurality of first test data corresponding respectively to the test data generators;
processing, by the integrated circuit to be tested, the plurality of first test data, to obtain a plurality of second test data; and
comparing, by a first comparator, consistency among the plurality of second test data, to obtain a first test result for the integrated circuit to be tested.

A third aspect of this disclosure provides a neural processing unit (NPU), the NPU including at least one circuit for performing functional safety test of the first aspect as described above.

A fourth aspect of this disclosure provides an electronic device, including:
a memory, configured for storing processor-executable instructions; and
a processor, configured for reading the processor-executable instructions from the memory, and executing the processor-executable instructions to implement a method for performing functional safety test on an integrated circuit of the second aspect as described above.

A fifth aspect of this disclosure provides a computer readable storage medium, storing a computer program for implementing a method for performing functional safety test on an integrated circuit of the second aspect as described above.

With the circuit for performing functional safety test according to embodiments of this disclosure, just by processing the plurality of first test data using the integrated circuit to be tested and based on the obtained consistency among the plurality of second test data, the first test result for the integrated circuit to be tested may be determined, implementing FuSa test on circuits in the integrated circuit to be tested. When performing FuSa test on the integrated circuit to be tested using the circuit for performing functional safety test according to this disclosure, not only it is enabled to meet the expected FuSa standard, it is also not required to attach a parity bit to the data transmitted by the integrated circuit to be tested, which therefore enables to reduce the area overhead for the IC, and lower the data transmission power consumption.

### BRIEF DESCRIPTION OF THE DRAWINGS

FIG. 1 is a schematic diagram of a structure of a circuit for performing functional safety test according to an illustrative embodiment of this disclosure, which performs FuSa protection by parity check.
FIG. 2 is a schematic diagram of a structure of a circuit for performing functional safety test according to an illustrative embodiment of this disclosure.
FIG. 3 is a schematic diagram of a structure of another circuit for performing functional safety test according to an illustrative embodiment of this disclosure.
FIG. 4 is a schematic diagram of a structure of still another circuit for performing functional safety test according to an illustrative embodiment of this disclosure.
FIG. 5 is a schematic diagram of a structure of still another circuit for performing functional safety test according to an illustrative embodiment of this disclosure.
FIG. 6 is a schematic diagram of a structure of still another circuit for performing functional safety test according to an illustrative embodiment of this disclosure.
FIG. 7 is a flowchart of a method for performing functional safety test on an integrated circuit according to an illustrative embodiment of this disclosure.
FIG. 8 is a flowchart of another method for performing functional safety test on an integrated circuit according to an illustrative embodiment of this disclosure.
FIG. 9 is a flowchart of still another method for performing functional safety test on an integrated circuit according to an illustrative embodiment of this disclosure.
FIG. 10 is a flowchart of still another method for performing functional safety test on an integrated circuit according to an illustrative embodiment of this disclosure.
FIG. 11 is a schematic diagram of a structure of a neural processing unit (NPU) according to an illustrative embodiment of this disclosure.
FIG. 12 is a schematic diagram of a structure of an electronic device according to an illustrative embodiment of this disclosure.

### DETAILED DESCRIPTION OF THE EMBODIMENTS

To explain this disclosure, illustrative embodiments of this disclosure are elaborated below with reference to accompanying drawings. Clearly, the embodiments described are merely some, rather than all, embodiments of this disclosure. It should be understood that this disclosure is not limited to the illustrative embodiments.

It should be noted that unless otherwise specified, the scope of this disclosure is not limited to relative arrangements, numeric expressions, and numerical values of components and steps described in these embodiments.

### Disclosure overview

In the field of ICs, a FuSa mechanism is an important technical means ensuring safe, reliable run of an integrated circuit system (such as a system on chip, SOC). Generally, different modes of FuSa test may be used for circuits of different functions and features in the integrated circuit system.

In related art, for an integrated circuit of simple logic, a lot of operation circuits, and a great circuit area, FuSa test is performed mainly by parity check. Taking the integrated circuit being a tensor computing core (tensor core) in a neural processing unit (NPU) as an example, when performing FuSa test on the tensor computing core by parity check, a parity bit is to be attached to data transmitted by the tensor computing core in actual run, and it is to be detected, based on the data transmitted with the parity bit attached, whether a fault occurs to a line configured for data transmission, to implement FuSa test on the tensor computing core.

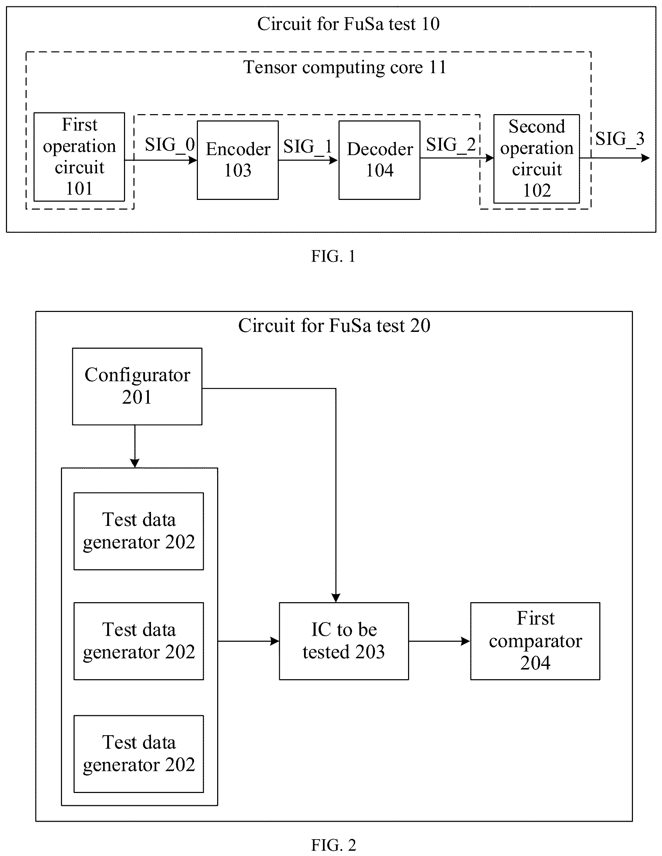

FIG. 1 is a schematic diagram of a structure of a circuit for performing functional safety test according to an illustrative embodiment of this disclosure, which performs FuSa test by parity check. The circuit 10 for performing functional safety test is configured for performing FuSa test on a tensor computing core 11. As shown in FIG. 1, the circuit 10 for performing functional safety test may include a first operation circuit 101, an encoder 103, a decoder 104, and a second operation circuit 102 coupled in sequence. The tensor computing core 11 includes the first operation circuit 101 and the second operation circuit 102. The encoder 103 and the decoder 104 are a detecting circuit set between the first operation circuit 101 and the second operation circuit 102 when performing FuSa test on the tensor computing core 11.

A process of performing FuSa test on the tensor computing core 11 by parity check is illustrated below.

First, the encoder 103 attaches a parity bit to an output signal SIG_0 of the first operation circuit 101, to obtain and output an encoded signal SIG_1. Then, the decoder 104 decodes the encoded signal SIG_1, to obtain a decoded signal SIG_2, which is output to the second operation circuit 102. The second operation circuit 102 performs corresponding operation processing on the decoded signal SIG_2, to obtain and output an operated signal SIG_3.

When performing FuSa test on the tensor computing core 11, the decoder 104 further may compute a number of logic values "1" in the received encoded signal SIG_1, to determine parity of the received SIG_1; and determine, according to consistency between the parity indicated by the number of logic values "1" and parity indicated by the parity bit, whether an abnormality occurs when the encoded signal SIG_1 is transmitted between the first operation circuit 101 and the second operation circuit 102, thus implementing FuSa test on the first operation circuit 101 and the second operation circuit 102.

In case another operation circuit further is coupled to a subsequent stage of the second operation circuit 102, an encoder and a decoder coupled in sequence may be set between the second operation circuit 102 and the another operation circuit. Similarly, decoding processing and encoding processing are performed in sequence on the operated signal SIG_3 using the encoder and the decoder, to implement FuSa test on the second operation circuit 102 and the another operation circuit.

When performing FuSa test on the tensor computing core using parity check as described above, it may be detected just whether an abnormality occurs to the line configured for data transmission in the tensor computing core, but it fails to detect whether an abnormality occurs to an operation circuit in the tensor computing core, and FuSa test cannot be performed on all of the circuits in the entire tensor computing core, therefore failing to meet an expected FuSa standard. Moreover, the encoded signal is a signal obtained by attaching the parity bit to the data transmitted, with a bit width greater than that of the data transmitted. Therefore, to transmit the encoded signal using a line between the operation circuits, an area of the line between the operation circuits is to be increased, thus to increase an area overhead for the IC. Meanwhile, when transmitting the encoded signal with the parity bit attached using the line between the operation circuits, greater data transmission power consumption also is to be produced.

Based on a technical problem described above, embodiments of this disclosure provide a circuit for performing functional safety test, which generates, by a configurator, configuration information for performing FuSa test on an integrated circuit (IC) to be tested; then generates, by a plurality of test data generators and based on the configuration information, a plurality of first test data; then processes, by the integrated circuit to be tested, the plurality of first test data, to obtain a plurality of second test data; and finally, compares, by a first comparator, consistency among the plurality of second test data, to obtain a first test result for the integrated circuit to be tested.

In this way, just by processing the plurality of first test data using the integrated circuit to be tested and based on the obtained consistency among the plurality of second test data, the first test result for the integrated circuit to be tested may be determined, implementing FuSa test on the integrated circuit to be tested. When performing FuSa test on the integrated circuit to be tested using the circuit for performing functional safety test according to this disclosure, not only it is enabled to meet the expected FuSa standard, it is also not required to attach a parity bit to the data transmitted by the integrated circuit to be tested, which therefore enables to reduce the area overhead for the IC, and lower the data transmission power consumption.

### Illustrative circuit

FIG. 2 is a schematic diagram of a structure of a circuit for performing functional safety test according to an illustrative embodiment of this disclosure. As shown in FIG. 2, the circuit 20 for performing functional safety test includes a configurator 201, a plurality of test data generators 202, an integrated circuit 203 to be tested, and a first comparator 204.

The configurator 201 is configured for generating configuration information for testing an integrated circuit (IC) 203 to be tested, and outputting the configuration information; the plurality of test data generators 202 are coupled to the configurator 201, and are configured for generating and outputting, based on the configuration information, a plurality of first test data corresponding respectively to the test data generators 202; the integrated circuit 203 to be tested is coupled to the plurality of test data generators 202, and is configured for processing the plurality of first test data, to obtain and output a plurality of second test data; and the first comparator 204 is coupled to the integrated circuit 203 to be tested, and is configured for comparing consistency among the plurality of second test data, to obtain a first test result for the integrated circuit 203 to be tested.

Illustratively, the configurator 201 may be address generation units (AGU) on an vehicle-mounted SOC which are configured for performing instruction analysis and control. And, the configurator 201 may include a control input and a configuration output. The control input of the configurator 201 is configured for receiving a test instruction output by a compiler. The configurator 201 is configured for generating, in response to the test instruction, the configuration information for performing FuSa test on the integrated circuit 203 to be tested, and outputting the configuration information through the configuration output.

In some embodiments, the configuration information may include an instruction for configuring a test data generator 202 to generate test data, and a type of an instruction included in the configuration information is related to a mode of test for performing FuSa test on the integrated circuit 203 to be tested.

Illustratively, the mode of test for performing FuSa test on the integrated circuit 203 to be tested may include a random data test and a preset data test. If the mode of test is the random data test, then the configuration information includes a start test instruction and a close test instruction. If the mode of test is the preset data test, i.e., performing test using fixed test data, then the configuration information includes not only the start test instruction and the close test instruction, but also a control instruction configured for controlling a test data generator 202 to generate preset test data. Specific content of the configuration information is not limited in embodiments of this disclosure. An embodiment below is illustrated taking the configuration information including the start test instruction and the close test instruction as an example.

Illustratively, depending on a mode of test, the plurality of test data generators 202 may include at least one type of data generators. In some examples, the plurality of test data generators 202 may include a plurality of random data generators, or a plurality of preset data generators.

A random data generator is configured for generating random test data, and the random test data are uncontrollable unknown test data. Therefore, in response to a start test instruction, a random data generator may generate different test data at different moments.

A preset data generator is configured for generating preset test data, and the preset test data are test data corresponding to a control instruction. Therefore, in response to a start test instruction and different control instructions, a preset data generator may generate preset test data corresponding respectively to the control instructions.

In some other examples, the plurality of test data generators 202 may include at least one random data generator and at least one preset data generator. A type of a data generator included in the plurality of test data generators 202 is related to a circuit structure of the integrated circuit 203 to be tested.

For example, if the integrated circuit 203 to be tested includes a plurality of data processing circuit, and the data processing circuits respectively include a plurality of identical data processing sub-circuits, then FuSa test may be performed on the integrated circuit 203 to be tested using identical test data or different test data. Thus, the plurality of test data generators 202 may be random data generators or preset data generators.

As another example, if the integrated circuit 203 to be tested includes a plurality of data processing circuits, and at least some of the plurality of data processing circuits include different data processing sub-circuits, then FuSa test may be performed on the integrated circuit 203 to be tested using just identical test data. Thus, the plurality of test data generators 202 may be preset data generators.

The number of the plurality of test data generators 202 is related to the circuit structure of the integrated circuit 203 to be tested. In some examples, the number of the plurality of test data generators 202 corresponds to the number of data inputs included in the integrated circuit 203 to be tested. For example, the integrated circuit 203 to be tested includes 3 data inputs, then the plurality of test data generators 202 include 3 test data generators 202. Taking the test data generators 202 being random data generators as an example, the plurality of test data generators 202 may include a first random data generator, a second random data generator, and a third the random data generator.

Illustratively, the plurality of test data generators 202 respectively include a configuration input and a data output. The respective configuration inputs of the test data generators 202 are coupled to the configuration output of the configurator 201.

Take the test data generators 202 being random data generators, and the configuration information including the start test instruction as an example. In some examples, a test data generator 202 is configured for receiving the start test instruction output by the configurator 201, generating random test data in response to the start test instruction, and outputting the random test data through the data output. In this case, first test data corresponding to the test data generator 202 are random test data.

Take the test data generators 202 being preset data generators, and the configuration information including the start test instruction and the control instruction configured for generating preset test data as an example. In some other examples, a test data generator 202 is configured for receiving the start test instruction and the control instruction output by the configurator 201; generating, in response to the start test instruction and the control instruction, the preset test data corresponding to the control instruction; and outputting the preset test data through the data output. In this case, first test data corresponding to the test data generator 202 are preset test data.

Illustratively, the first test data may be a test sequence including a plurality of first levels and second levels. In some examples, a first level may be a logic low level "0", and a second level may be a logic high level "1"; in some other examples, the first level may be the logic high level "1", and the second level may be the logic low level "0". A specific level of the first level and the second level is not limited in embodiments of this disclosure. Embodiments of this disclosure are illustrated taking the first level being the logic low level "0", and the second level being the logic high level "1" as an example.

In some examples, to cover multiple possibilities to improve test accuracy, the first test data may be a test sequence with a number of flips between the high level and the low level being greater than a preset number. Taking the preset number being 5, and one flip being shifting from the low level 0 to the high level 1 and then from the high level 1 to the low level 0 as an example, for example, the first test data may be 010110001001110011110000.

In some examples, the first test data may correspond to the type of the test data generators 202. If the type of the test data generators 202 is of random data generators, then the first test data are a random test sequence, and also may be referred to as random test data; if the type of the test data generators 202 is of preset data generators, then the first test data are a preset test sequence, and also may be referred to as preset test data.

The first test data generated respectively by the plurality of test data generators 202 may be identical or different. Consistency among the first test data generated respectively by the test data generators 202 is not limited in embodiments of this disclosure. Embodiments of this disclosure are illustrated taking the first test data generated respectively by the test data generators 202 being different as an example.

In some examples, if the test data generators 202 respectively are a random data generator, then the first test data generated respectively by the test data generators 202 may differ. In some other examples, if the test data generators 202 respectively are a preset data generator, and the test data generators 202 receive and respond to the same control instruction, then the test data generators 202 generate identical first test data.

In embodiments of this disclosure, the integrated circuit 203 to be tested may be any one integrated circuit of simple logic, a lot of operation circuits, and a great area in the SOC. In some examples, the integrated circuit 203 to be tested may be an integrated circuit on the SOC other than the NPU. For example, the integrated circuit 203 to be tested may be a tensor computing core beyond the NPU of the SOC. In some other examples, the integrated circuit 203 to be tested also may be an integrated circuit in the NPU of the SOC. For example, the integrated circuit 203 to be tested may be the tensor computing core in the NPU of the SOC. Embodiments of this disclosure are illustrated taking the integrated circuit 203 to be tested being the tensor computing core in the NPU of the SOC as an example.

The data inputs of the integrated circuit 203 to be tested are coupled to the data outputs of the plurality of test data generators 202, for receiving the first test data output by the test data generators 202, to obtain the plurality of first test data.

Illustratively, the configurator 201 further includes a control output. The configurator 201 is further configured for: generating, based on the test instruction output by the compiler, a circuit control signal configured for controlling the integrated circuit 203 to be tested to perform respective data processing; and outputting the circuit control signal through the control output.

The integrated circuit 203 to be tested further includes the control signal input. The control signal input is coupled to the control output of the configurator 201, for receiving the circuit control signal. The integrated circuit 203 to be tested is configured for performing preprocessing, arithmetic operation processing, and post-processing on the plurality of first test data in sequence in response to the circuit control signal, to obtain the plurality of second test data.

Illustratively, there may be one or a plurality of first comparators 204, wherein a number of the first comparator(s) 204 is related to a number of the plurality of second test data. In some examples, the number of first comparators 204 is half the number of the plurality of second test data. For example, if the number of the plurality of second test data is 64, then the number of first comparators 204 is 32.

Take the number of the plurality of second test data being 64, and the number of the first comparators 204 being 32 as an example. The 64 second test data may be divided into groups of two second test data, to obtain 32 groups of second test data; and consistency among the 32 groups of second test data is compared using the 32 comparators, respectively, which enables to obtain 32 first comparison results. Then, the 32 first comparison results may be determined to be the first test result for the integrated circuit 203 to be tested.

In some examples, if the first level indicates that a group of test data to be compared are identical, and the second level indicates that a group of test data to be compared differ, then when the 32 first comparison results respectively are the first level, it may be determined that the first test result for the integrated circuit 203 to be tested is test passed; and when at least one first comparison result of the 32 first comparison results is the second level, it may be determined that the first test result for the integrated circuit 203 to be tested is test failed.

In some other examples, if the first level indicates that a group of test data to be compared differ, and the second level indicates that a group of test data to be compared are identical, then when the 32 first comparison results include at least one first level, it may be determined that the first test result for the integrated circuit 203 to be tested is test failed; and when the 32 first comparison results respectively are the second level, it may be determined that the first test result for the integrated circuit 203 to be tested is test passed. Specific implementation of the first level and the second level is previously described, and therefore is not elaborated in embodiments of this disclosure here.

With the circuit for performing functional safety test according to embodiments of this disclosure, just by processing the plurality of first test data using the integrated circuit to be tested and based on the obtained consistency among the plurality of second test data, the first test result for the integrated circuit to be tested may be determined, implementing FuSa protection on circuits in the integrated circuit to be tested. When performing FuSa test on the integrated circuit to be tested using the circuit for performing functional safety test according to this disclosure, not only it is enabled to meet the expected FuSa standard, it is also not required to attach a parity bit to the data transmitted by the integrated circuit to be tested, which therefore enables to reduce the area overhead for the IC, and lower the data transmission power consumption.

The configuration information is related to the mode of test of the integrated circuit 203 to be tested, and the mode of test of the integrated circuit 203 to be tested is related to the circuit structure of the integrated circuit 203 to be tested. Therefore, the configurator 201 may generate different configuration information for to-be-tested integrated circuits 203 with different structures. Then, the test data generators 202 may generate first test data corresponding respectively to the different configuration information.

In some embodiments of this disclosure, the first test data may include random test data or preset test data. The test data generators 202 are configured for, in response to the configuration information including first sub-configuration information corresponding to a random data test, generating random test data; or, the test data generators 202 are configured for, in response to the configuration information including second sub-configuration information corresponding to a preset data test, generating preset test data.

Illustratively, if the mode of test for performing FuSa test on the integrated circuit 203 to be tested is the random data test, then the first sub-configuration information may include an instruction for configuring the test data generators 202 to generate random test data. For example, the first sub-configuration information may include the start test instruction and the close test instruction.

If the mode of test for performing FuSa test on the integrated circuit 203 to be tested is the preset data test, then the second sub-configuration information may include an instruction for configuring the test data generators 202 to generate preset test data. For example, the second sub-configuration information may include the start test instruction, the close test instruction, and the control instruction configured for controlling the test data generators 202 to generate preset test data.

With the circuit for performing functional safety test according to embodiments of this disclosure, in case the configuration information includes the first sub-configuration information corresponding to random test data, the test data generators are enabled to accordingly generate random test data for performing random data test on the integrated circuit to be tested, which thereby enables to perform random data test on the integrated circuit to be tested based on the random test data, meeting an actual test need for performing FuSa test on the integrated circuit to be tested. In case the configuration information includes the second sub-configuration information corresponding to the preset data test, the test data generators are enabled to accordingly generate preset test data for performing preset data test on the integrated circuit to be tested, which thereby enables to perform preset data test on the integrated circuit to be tested based on the preset test data, meeting the actual test need for performing FuSa test on the integrated circuit to be tested.

In some other embodiments of this disclosure, if the mode of test for performing FuSa test on the integrated circuit 203 to be tested is the preset data test, then the circuit 20 for performing functional safety test may not include the configurator 201 and the plurality of test data generators 202. The circuit 20 for performing functional safety test may obtain the first test data by: first writing the preset test data for the integrated circuit 203 to be tested in a preset storage area, and in case of performing FuSa test on the integrated circuit 203 to be tested, reading the preset test data through an external bus from the preset storage area. In this way, it is enabled to reduce the area overhead for the integrated circuit to be tested.

Take the integrated circuit 203 to be tested being the tensor computing core in the NPU of the SOC as an example. The integrated circuit 203 to be tested may include a plurality of first data converting circuits, an arithmetic logic circuit, and a second data converting circuit. The plurality of first data converting circuits may be configured for preprocessing the plurality of first test data, to obtain and output a plurality of preprocessed first test data. The arithmetic logic circuit may be configured for performing arithmetic operation on the plurality of preprocessed first test data, to obtain a plurality of arithmetic operation data. The second data converting circuit is configured for post-processing the plurality of arithmetic operation data, to obtain the plurality of second test data.

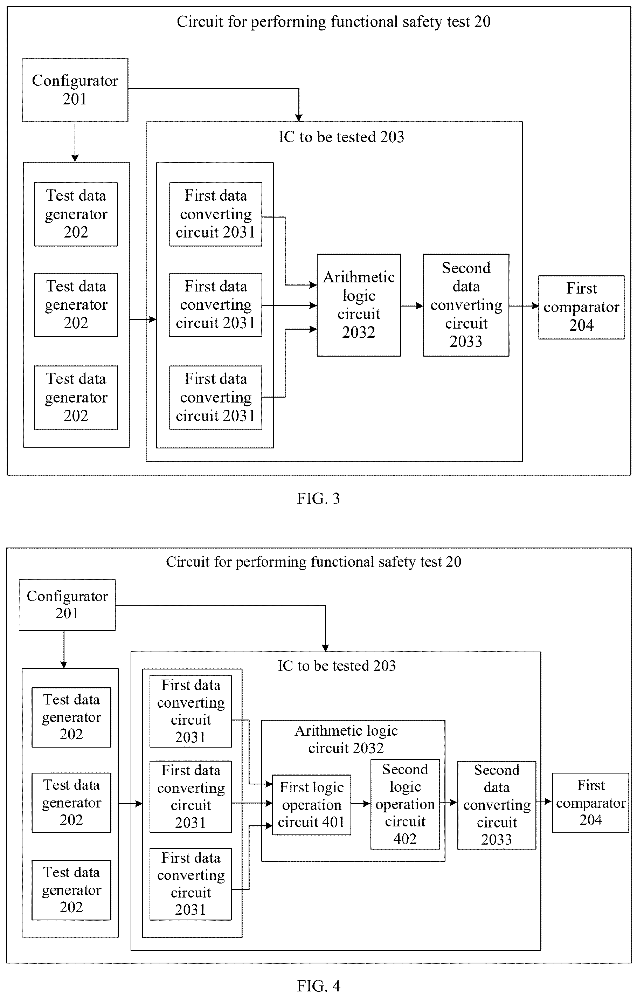

As shown in FIG. 3, based on the embodiment shown in FIG. 2 as described above, the integrated circuit 203 to be tested may include a plurality of first data converting circuits 2031, an arithmetic logic circuit 2032, and a second data converting circuit 2033.

Data inputs of the plurality of first data converting circuits 2031 are the data inputs of the integrated circuit 203 to be tested, and the data inputs of the first data converting circuits 2031 are coupled to the data outputs of the plurality of test data generators 202. Data outputs of the plurality of first data converting circuits 2031 are coupled to a data input of the arithmetic logic circuit 2032.

The plurality of first data converting circuits 2031 are configured for performing a first data conversion on the plurality of first test data, to obtain and output a plurality of first converted data.

A data output of the arithmetic logic circuit 2032 is coupled to a data input of the second data converting circuit 2033. The arithmetic logic circuit 2032 is configured for receiving the plurality of first converted data, and performing arithmetic operation on the plurality of first converted data, to obtain and output a plurality of arithmetic operation data.

A data output of the second data converting circuit 2033 is a data output of the integrated circuit 203 to be tested, and is coupled to the first comparator 204. The second data converting circuit 2033 is configured for performing a second data conversion on the plurality of arithmetic operation data, to obtain and output the plurality of second test data.

Illustratively, the first data conversion may correspond to preprocessing as described above, and the first data conversion may include processing such as data structure or data format conversion, data pipelining, data selection, etc. The first converted data may be the data obtained by performing processing such as data structure or data format conversion, data pipelining, data selection, etc., on the plurality of first test data. A goal of performing the first data conversion on the first test data is to convert the first test data into data meeting a requirement on an input of the arithmetic logic circuit 2032, such that the first converted data meet the requirement on the input of the arithmetic logic circuit 2032.

Illustratively, referring to what shown in FIG. 3, the plurality of first data converting circuits 2031 respectively may include a plurality of first data converting sub-circuits coupled in parallel, and data inputs of the plurality of first data converting sub-circuits are coupled to the data outputs of the plurality of test data generators 202. In some examples, the first data converting sub-circuits in a first data converting circuit 2031 may simultaneously receive the plurality of first test data output by the plurality of test data generators 202, and simultaneously process the plurality of first test data. For example, the first data converting sub-circuits may be configured for receiving the plurality of first test data, performing processing such as data structure or data format conversion, data pipelining, data selection, etc., on the plurality of first test data, to obtain the first converted data meeting the requirement on the input of the arithmetic logic circuit 2032. Then, it is enabled to obtain the plurality of first converted data using the first data converting circuit 2031.

In embodiments of this disclosure, a number of the plurality of first data converting circuits 2031 and a number of the first data converting sub-circuits in a first data converting circuit 2031 are related to the circuit structure of the integrated circuit 203 to be tested.

In some examples, the number of the plurality of first data converting circuits 2031 corresponds to the number of data inputs included in the integrated circuit 203 to be tested. One data input thereof may correspondingly receive one group of data source data. For example, if the integrated circuit 203 to be tested receives 3 groups of data source data, i.e., the integrated circuit 203 to be tested includes 3 data inputs, then the number of the plurality of first data converting circuits 2031 is 3. The number of the plurality of first data converting circuits 2031 is not limited in embodiments of this disclosure. An embodiment below is illustrated taking the number of the plurality of first data converting circuits 2031 being 3 as an example.

In some other examples, the number of the first data converting sub-circuits in a first data converting circuit 2031 corresponds to parallelism of the integrated circuit 203 to be tested. The parallelism refers to a number of respective data the integrated circuit 203 to be tested may process simultaneously. For example, if the IC to be tested may simultaneously process 8 data, then a first data converting circuit 2031 may include 8 first data converting sub-circuits. As another example, if the IC to be tested may simultaneously process 32 data, then a first data converting circuit 2031 may include 32 first data converting sub-circuits. The number of the first data converting sub-circuits in a first data converting circuit 2031 is not limited in embodiments of this disclosure. Embodiments of this disclosure are illustrated taking as an example that: the number of the first data converting circuits 2031 is 3, wherein a first data converting circuit 2031a thereof may include 8 first data converting sub-circuits, a first data converting circuit 2031b thereof may include 32 second data converting sub-circuits, and a first data converting circuit 2031c thereof may include 8 third data converting sub-circuits.

Illustratively, the plurality of first data converting circuits 2031 respectively include a control signal terminal, and the control signal terminal is coupled to the control output of the configurator 201.

For example, the first data converting circuit 2031a includes a first control signal terminal, and the first control signal terminal is coupled to the control output of the configurator 201. The circuit control signal output by the configurator 201 may include a first control signal corresponding to the first data converting circuit 2031a. The first data converting circuit 2031a is configured for receiving the first control signal, and in response to the first control signal, selecting a plurality of first data converting sub-circuits in the 8 first data converting sub-circuits included in the first data converting circuit 2031a to perform processing such as data structure or data format conversion, data pipelining, data selection, etc., on the plurality of first test data, to obtain the plurality of first converted data.

Illustratively, the arithmetic logic circuit 2032 may be an arithmetic logic unit (ALU), and may include a plurality of adders, a plurality of multipliers, a plurality of saturation logic circuits, and a plurality of shift logic circuits.

In some examples, the arithmetic logic circuit 2032 also includes a control signal terminal, and the control signal terminal of the arithmetic logic circuit 2032 is coupled to the control output of the configurator 201. Correspondingly, the circuit control signal output by the configurator 201 may include a second control signal corresponding to the arithmetic logic circuit 2032. The arithmetic logic circuit 2032 is configured for receiving the second control signal, and in response to the second control signal, selecting at least one adder, at least one multiplier, at least one saturation logic circuit, and at least one shift logic circuit in the arithmetic logic circuit 2032 to perform arithmetic operation on the plurality of first converted data, to obtain the plurality of arithmetic operation data.

Illustratively, the second data conversion also may be referred to as post-processing. Similar to the first data conversion, the second data conversion also may include processing such as data structure or data format conversion, data pipelining, data selection, etc. Second converted data may be data obtained by performing processing such as data structure or data format conversion, data pipelining, data selection, etc., on the arithmetic operation data. In this disclosure, a goal of performing the second data conversion on the arithmetic operation data is to convert the arithmetic operation data into data meeting a requirement on an input of a post-stage circuit of the integrated circuit 203 to be tested, such that the second converted data meet the requirement on the input of the post-stage circuit of the integrated circuit 203 to be tested.

Similar to a first data converting circuit 2031, the second data converting circuit 2033 may include a plurality of fourth data converting sub-circuits. Data inputs of the fourth data converting sub-circuits respectively are coupled to the data output of the arithmetic logic circuit 2032. The fourth data converting sub-circuits are configured for receiving the arithmetic operation data, and performing processing such as data structure or data format conversion, etc., on the arithmetic operation data, to obtain the second test data meeting the requirement on the input of the post-stage circuit of the integrated circuit 203 to be tested.

In some examples, the second data converting circuit 2033 also may include a control signal terminal, and the control signal terminal is coupled to the configurator 201. Correspondingly, the circuit control signal output by the configurator 201 may include a third control signal corresponding to the second data converting circuit 2032. The second data converting circuit 2033 is configured for: receiving the third control signal; selecting, in response to the third control signal, at least one fourth data converting sub-circuit of the plurality of fourth data converting sub-circuits included in the second data converting circuit 2033; and performing processing such as data structure or data format conversion, data pipelining, data selection, etc., on a plurality of arithmetic operation data using the selected at least one fourth data converting sub-circuit, to obtain the plurality of second test data.

In the circuit for performing functional safety test according to embodiments of this disclosure, first data conversion is performed on the plurality of first test data using the plurality of first data converting circuits, which enables to obtain the plurality of first converted data suitable to be processed by the arithmetic logic circuit. Arithmetic operation is performed on the plurality of first converted data using the arithmetic logic circuit, which enables to implement data operation processing on the first test data. Then a second data conversion is performed on a plurality of arithmetic operation data using the second data converting circuit, which enables to obtain the plurality of second test data suitable to be processed by the post-stage circuit. Thereby, it is enabled to implement FuSa test on the IC to be tested.

In some embodiments of this disclosure, the arithmetic logic circuit 2032 may include at least one logic operation circuit, and the number of the logic operation circuit(s) included in the arithmetic logic circuit 2032 and a function of a logic operation circuit are related to a function and devising of the integrated circuit 203 to be tested. The number and the function of the logic operation circuit(s) included in the arithmetic logic circuit 2032 are not limited in embodiments of this disclosure. Embodiments of this disclosure are illustrated taking as an example that the arithmetic logic circuit 2032 includes a first logic operation circuit and a second logic operation circuit.

As shown in FIG. 4, based on the embodiment shown in FIG. 3 as described above, the arithmetic logic circuit 2032 includes a first logic operation circuit 401 and a second logic operation circuit 402.

A data input of the first logic operation circuit 401 is the data input of the arithmetic logic circuit 2032, and is coupled to the data outputs of the plurality of first data converting circuits 2031, and a data output of the first logic operation circuit 401 is coupled to a data input of the second logic operation circuit 402. The first logic operation circuit 401 is configured for performing a first logic operation on the plurality of first converted data, to obtain and output a plurality of first operated data.

A data output of the second logic operation circuit 402 is the data output of the arithmetic logic circuit 2032, and is coupled to the data input of the second data converting circuit 2033. The second logic operation circuit 402 is configured for performing second logic operation processing on the plurality of first operated data, to obtain and output the plurality of arithmetic operation data.

Illustratively, the first logic operation circuit 401 may include a plurality of adders of identical computing logics and/or a plurality of multipliers of identical computing logics. For example, the first logic operation circuit 401 may include 4k (thousands) of adders and 4k multipliers. As another example, the first logic operation circuit 401 may include 8k adders and 8k multipliers. Correspondingly, the first logic operation circuit 401 may be configured for performing addition and multiplication on the plurality of first converted data, to obtain the plurality of first operated data.

In some examples, the first logic operation circuit 401 includes a first control signal sub-terminal, and the first control signal sub-terminal is coupled to the configurator 201. Correspondingly, the second control signal may include a first sub-control signal corresponding to the first logic operation circuit 401. The first logic operation circuit 401 is configured for receiving the first sub-control signal, and selecting, in response to the first sub-control signal, at least one adder and at least one multiplier to perform addition and multiplication on the plurality of first converted data, to obtain the plurality of first operated data.

Similarly, the second logic operation circuit 402 may be a logic matrix including a plurality of identical logic circuits. The logic circuits in the logic matrix respectively may receive one first operated data output by the first logic operation circuit 401, and perform an operation such as addition, saturation, shift, quantization, table lookup, etc., on the one first operated data, to obtain the arithmetic operation data.

In some examples, the second logic operation circuit 402 include a second control signal sub-terminal, and the second control signal sub-terminal is coupled to the configurator 201. Correspondingly, the second control signal may include a second sub-control signal corresponding to the second logic operation circuit 402. The second logic operation circuit 402 is configured for receiving the second sub-control signal, and in response to the second sub-control signal performing at least one operation of addition, saturation, shift, quantization, table lookup, etc., respectively on the plurality of first operated data, to obtain the arithmetic operation data.

As there is a fuzzy operation such as saturation, quantization, etc., in the logic circuits in the second logic operation circuit 402, in determining the first test result for the integrated circuit 203 to be tested according to consistency among the second test data corresponding to the plurality of arithmetic operation data output by the second logic operation circuit 402, it fails to perform exhaustive fault coverage on a prior-stage circuit of the second logic operation circuit 402 in the integrated circuit 203 to be tested, i.e., fails to perform exhaustive fault coverage on the plurality of test data generators 202 and the first logic operation circuit 401, with a rate of test coverage of the integrated circuit 203 to be tested reaching just 90%, rather than 100%. To improve the rate of test coverage of the IC to be tested, with embodiments of this disclosure, in case of inputting the plurality of first operated data to the second logic operation circuit 402, a second comparator further may be set at the output of the first logic operation circuit 401, and the consistency among the plurality of first operated data output by the first logic operation circuit 401 is compared using the second comparator, to implement detection of the prior-stage circuit of the second logic operation circuit 402.

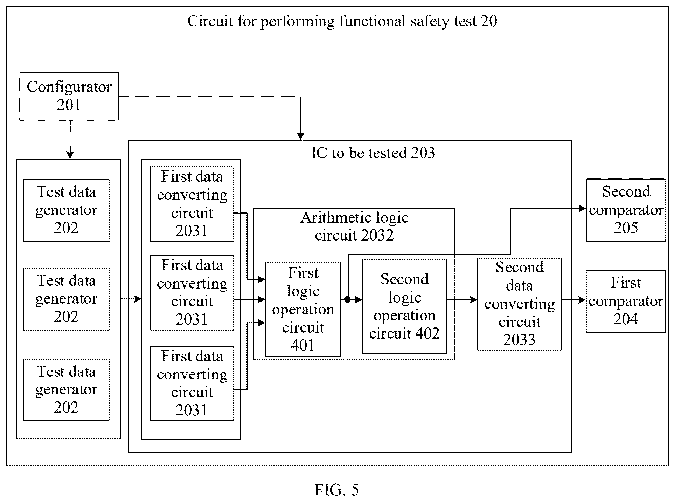

As shown in FIG. 5, based on the embodiment shown in FIG. 4 as described above, the circuit 20 for performing functional safety test further includes a second comparator 205.

A compared data input of the second comparator 205 is coupled to the output of the first logic operation circuit 401. The second comparator 205 is configured for comparing consistency among the plurality of first operated data, to obtain a second test result for the IC to be tested.

Similar to the first comparator 204, the second comparator 205 also includes at least one comparator, and the number of the comparator(s) in the second comparator 205 is related to an amount of data of the plurality of first operated data. Implementation of the second comparator 205 in embodiments of this disclosure is not elaborated here.

Illustratively, the second test result for the integrated circuit 203 to be tested may correspond to a test result for the prior-stage circuit of the second logic operation circuit 402 in the integrated circuit 203 to be tested, and may be determined based on the consistency among the plurality of first operated data. In some examples, if the plurality of first operated data are consistent, then it is determined that the prior-stage circuit of the second logic operation circuit 402 passes the test. In some other examples, if the plurality of first operated data are inconsistent, then it is determined that the prior-stage circuit of the second logic operation circuit 402 fails the test.

Take the number of the plurality of first operated data being 64, and the second comparator 205 including 32 comparators as an example. The 64 first operated data may be divided into groups of two first operated data, to obtain 32 groups of first operated data. Then, consistency among the 32 groups of first operated data is respectively compared using the 32 second comparators 205, i.e., one comparator comparing one group of first operated data, which enables to obtain 32 second comparison results. And, the 32 second comparison results may be determined to be the second test result for the integrated circuit 203 to be tested. As implementation of the second comparison result is similar to that of the first comparison result, the second comparison result is not elaborated here in embodiments of this disclosure.

If the 32 second comparison results are identical, for example, the 32 second comparison results respectively are the first level or the second level, then it is determined that the second test result for the integrated circuit 203 to be tested is test passed. If the 32 second comparison results include different second comparison results, for example, the 32 second comparison results include one first level and 31 second levels, then it is determined that the second test result for the integrated circuit 203 to be tested is test failed.

With the circuit for performing functional safety test according to embodiments of this disclosure, the consistency among the plurality of first operated data is compared using the second comparator, to obtain the second test result for the IC to be tested. In this way, it is enabled to implement detection of the prior-stage circuit of the second logic operation circuit in the IC to be tested, improving the rate of test coverage of the IC to be tested.

In some embodiments of this disclosure, the second comparator 205 further is configured for: in response to the first test data being preset test data, determining expected data corresponding to the preset test data, and comparing consistency between the first operated data and the expected data, to obtain the second test result; or in response to the first test data being random test data, comparing the consistency among the plurality of first operated data, to obtain the second test result.

Illustratively, the expected data may be data output by the first logic operation circuit 401 when the preset test data are input to the integrated circuit 203 to be tested. In some examples, the expected data may be inferred based on the circuit structure of the integrated circuit 203 to be tested. In some other examples, the expected data may be determined by performing an experiment on the integrated circuit 203 to be tested. A mode of obtaining the expected data is not limited in embodiments of this disclosure. Embodiments of this disclosure are illustrated taking as an example that the expected data are inferred based on the circuit structure of the integrated circuit 203 to be tested.

In embodiments of this disclosure, when performing FuSa test on the integrated circuit 203 to be tested using the preset test data, consistency between the data output by the first logic operation circuit 401 and the expected data may be compared using the second comparator 205, to obtain the second test result for the integrated circuit 203 to be tested. Thereby, it is enabled to perform accurate FuSa detection for the prior-stage circuit of the second logic operation circuit 402 based on the second test result.

In embodiments of this disclosure, when performing FuSa test on the integrated circuit 203 to be tested using the random test data, consistency among numbers output by the first logic operation circuit 401 may be compared directly using the second comparator 205, to obtain the second test result for the integrated circuit 203 to be tested. Thereby, accurate detection is performed on the prior-stage circuit of the second logic operation circuit 402 based on the second test result.

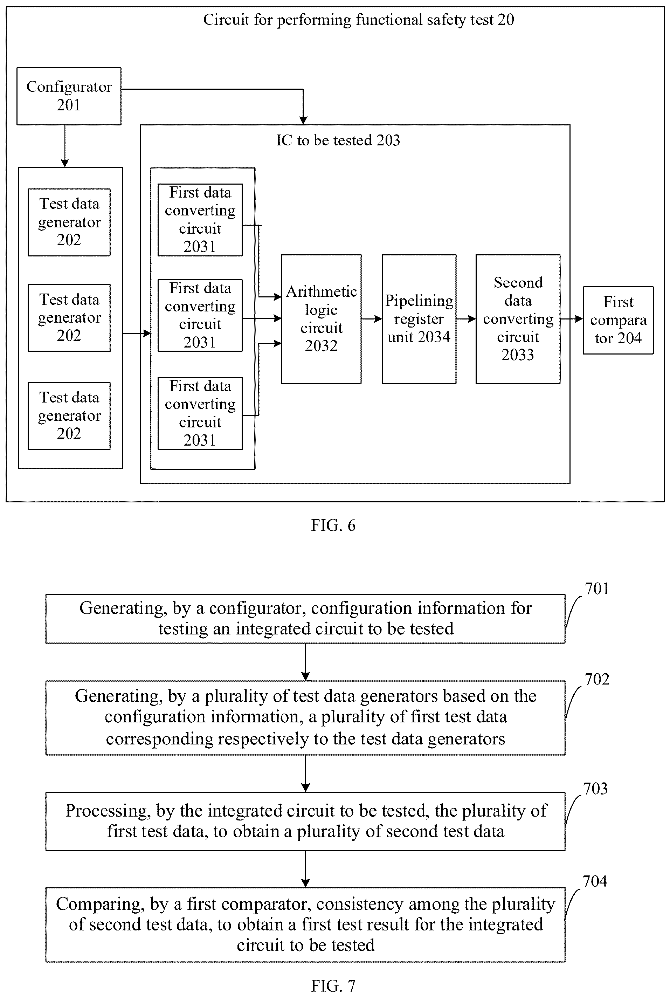

As shown in FIG. 6, based on the embodiment shown in FIG. 3 as described above, the integrated circuit 203 to be tested further includes a pipelining register unit 2034.

A data input of the pipelining register unit 2034 is coupled to the data output of the arithmetic logic circuit 2032, and an output of the pipelining register unit 2034 is coupled to the data input of the second data converting circuit 2033. The pipelining register unit 2034 is configured for temporarily storing the plurality of arithmetic operation data, and outputting the plurality of arithmetic operation data temporarily stored.

Correspondingly, the second data converting circuit 2033 is configured for receiving the plurality of arithmetic operation data temporarily stored, and performing the second data conversion on the plurality of arithmetic operation data temporarily stored, to obtain the plurality of second test data, and outputting the plurality of second test data to the first comparator 204.

Illustratively, the pipelining register unit 2034 may include at least one register. The number of the at least one register in the pipelining register unit 2034 is related to a timing requirement of the IC to be tested, and the number of the at least one register is not limited in embodiments of this disclosure.

With the circuit for performing functional safety test according to embodiments of this disclosure, the plurality of arithmetic operation data are temporarily stored using the pipelining register unit, which enables to adjust timing of the plurality of arithmetic operation data, ensuring correctness of timing within the IC to be tested.

### Illustrative method

FIG. 7 is a flowchart of a method for performing functional safety test on an integrated circuit according to an illustrative embodiment of this disclosure. The method for performing functional safety test is applicable to the circuit for performing functional safety test as described above, to implement FuSa test on the IC to be tested. As shown in FIG. 7, the method for performing functional safety test may include step 701 to step 704 as follows.

Step 701, Generating, by a configurator, configuration information for testing an integrated circuit (IC) to be tested.

Step 702, Generating, by a plurality of test data generators based on the configuration information, a plurality of first test data corresponding respectively to the test data generators.

Step 703,processing, by the IC to be tested, the plurality of first test data, to obtain a plurality of second test data.

Step 704, comparing, by a first comparator, consistency among the plurality of second test data, to obtain a first test result for the IC to be tested.

In some embodiments, the first test data include random test data or preset test data. Taking the first test data including the random test data as an example, step 702 specifically includes: generating the random test data using the test data generators in response to first sub-configuration information corresponding to a random data test. Taking the first test data including the preset test data as an example, step 702 specifically includes: generating the preset test data using the test data generators in response to second sub-configuration information corresponding to a preset data test.

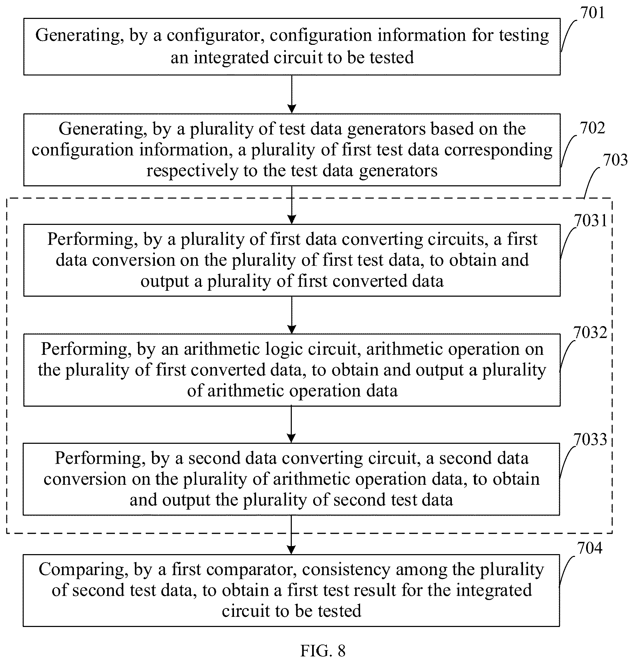

In some embodiments, the IC to be tested includes a plurality of first data converting circuits, an arithmetic logic circuit, and a second data converting circuit. As shown in FIG. 8, based on the embodiment shown in FIG. 7 as described above, step 703 may include step 7031 to step 7033 as follows.

Step 7031, Performing, by the plurality of first data converting circuits, a first data conversion on the plurality of first test data, to obtain and output a plurality of first converted data.

Step 7032, Performing, by the arithmetic logic circuit, arithmetic operation on the plurality of first converted data, to obtain and output a plurality of arithmetic operation data.

Step 7033, Performing, by the second data converting circuit, a second data conversion on the plurality of arithmetic operation data, to obtain and output the plurality of second test data.

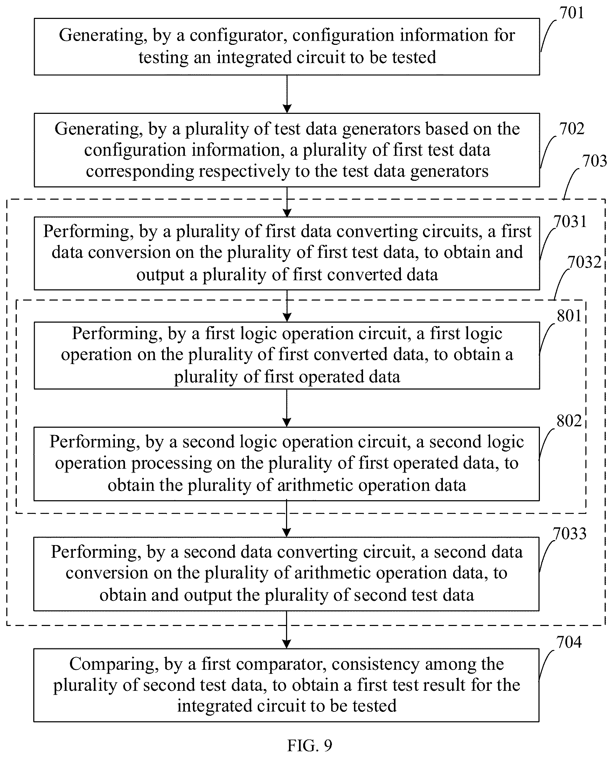

In some embodiments, the arithmetic logic circuit includes a first logic operation circuit and a second logic operation circuit. As shown in FIG. 9, based on the embodiment shown in FIG. 8 as described above, step 7032 include step 801 and step 802 as follows.

Step 801, Performing, by the first logic operation circuit, a first logic operation on the plurality of first converted data, to obtain a plurality of first operated data.

Step 802, Performing, by the second logic operation circuit, second logic operation processing on the plurality of first operated data, to obtain the plurality of arithmetic operation data.

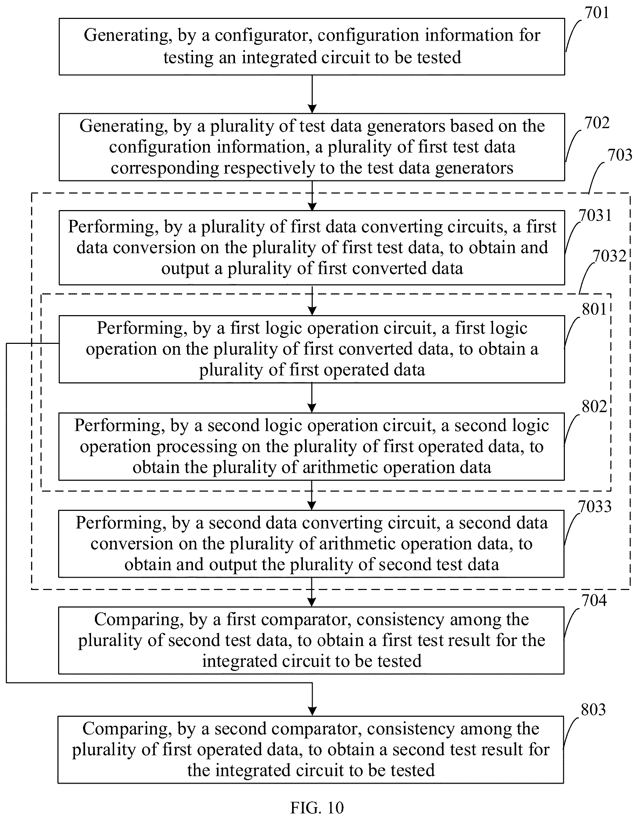

In some embodiments, the circuit for performing functional safety test further includes a second comparator. As shown in FIG. 10, based on the embodiment shown in FIG. 9 as described above, the method for performing FuSa test further may include step 803 as follows.

Step 803, Comparing, by the second comparator, consistency among the plurality of first operated data, to obtain a second test result for the IC to be tested.

In some embodiments, step 803 specifically includes: in response to the first test data being preset test data, determining, by the second comparator, expected data corresponding to the preset test data, and comparing consistency between the first operated data and the expected data, to obtain the second test result; or in response to the first test data being random test data, comparing, by the second comparator, the consistency among the plurality of first operated data, to obtain the second test result

In some examples, the IC to be tested further includes a pipelining register unit. As shown in FIG. 10, based on the embodiment shown in FIG. 8 as described above, step 7033 specifically includes: temporarily storing, by the pipelining register unit, the plurality of arithmetic operation data, and outputting the plurality of arithmetic operation data temporarily stored; and performing, by the second data converting circuit, the second data conversion on the plurality of arithmetic operation data temporarily stored, to obtain the plurality of second test data, and outputting the plurality of second test data to the first comparator.

Specific modes of executing steps in a method for performing functional safety test on an integrated circuit in an embodiment described above and respective beneficial effects thereof have been elaborated in respective embodiment sections in a foregoing section regarding the circuit for performing functional safety test, for which one may refer to respective operation executing modes of the "Illustrative circuit " section as described above and beneficial technical effects; and are not elaborated here.

In some embodiments of this disclosure, if the NPU of the SOC includes a plurality of tensor computing cores, the NPU includes a plurality of respective circuits for performing functional safety test.

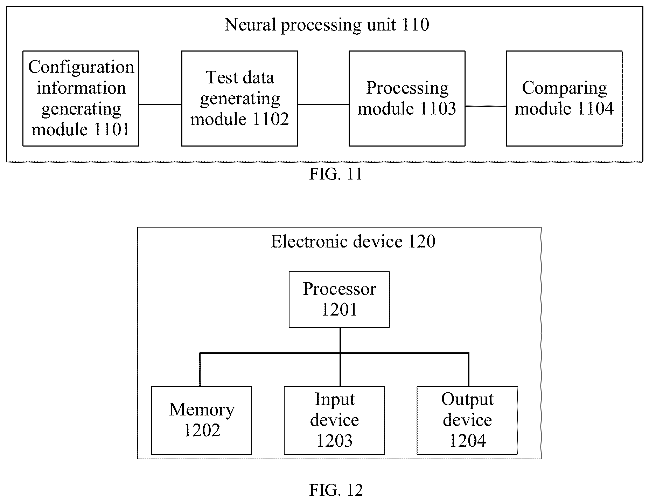

FIG. 11 is a schematic diagram of a structure of a neural processing unit (NPU) according to an illustrative embodiment of this disclosure. As shown in FIG. 11, the NPU 110 includes at least one circuit 20 for performing functional safety test as shown in FIG. 2.

### Illustrative electronic device

FIG. 12 is a schematic diagram of a structure of an electronic device according to an illustrative embodiment of this disclosure. As shown in FIG. 12, the electronic device 120 includes the one or plurality of processors 1201 and a memory 1202.

The processor 1201 may be a central processing unit (CPU) or another form of processing unit having a data processing capability and/or an instruction execution capability, and may control other components in the electronic device 120 to implement desired functions.

The memory 1202 may include one or more computer program products, which may include various forms of computer readable storage media, such as a volatile memory and/or a non-volatile memory. The volatile memory may include, for example, random access memory (RAM) and/or cache. The nonvolatile memory may include, for example, read-only memory (ROM), hard disk, and flash memory. One or more computer program instructions may be stored on the computer readable storage medium. The processor 1201 may execute the one or more computer program instructions to implement the method for performing functional safety test on an integrated circuit according to the various embodiments of this disclosure that are described above and/or other desired functions.

In an example, the electronic device 120 may further include an input device 1203 and an output device 1204. These components are coupled to each other through a bus system and/or another form of connection mechanism (not shown).

Certainly, for simplicity, FIG. 12 shows only some of components in the electronic device 120 that are related to this disclosure, and components such as a bus and an input/output interface are omitted. In addition, according to specific application situations, the electronic device 120 may further include any other appropriate components.

### Illustrative computer program product and computer readable storage medium

In addition to the foregoing method and device, embodiments of this disclosure may also be a computer program product, which includes computer program instructions. When the computer program instructions are run by a processor, the processor is enabled to perform the steps, of the method for performing functional safety test on an integrated circuit according to the embodiments of this disclosure, that are described in the "Illustrative method" section of this specification.

The computer program product may be program code, written with one or any combination of a plurality of programming languages, that is configured to perform the operations in the embodiments of this disclosure. The programming languages include an object-oriented programming language such as Java or C++, and further include a conventional procedural programming language such as a "C" language or a similar programming language. The program code may be entirely or partially executed on a user computing device, executed as an independent software package, partially executed on the user computing device and partially executed on a remote computing device, or entirely executed on the remote computing device or a server.

In addition, the embodiments of this disclosure may further relate to a computer readable storage medium, which stores computer program instructions. When the computer program instructions are run by the processor, the processor is enabled to perform the steps, of the method for performing functional safety test on an integrated circuit according to the embodiments of this disclosure, that are described in the "Illustrative method" section of this specification.

The computer readable storage medium may be one readable medium or any combination of a plurality of readable media. The readable medium may be a readable signal medium or a readable storage medium. The readable storage medium may include, for example but is not limited to electricity, magnetism, light, electromagnetism, infrared ray, or a semiconductor system, an apparatus, or a device, or any combination of the above. More specific examples (a non-exhaustive list) of the readable storage medium include: an electrical connection having one or more conducting wires, a portable disk, a hard disk, a random access memory (RAM), a read-only memory (ROM), an erasable programmable read-only memory (EPROM or a flash memory), an optical fiber, a portable compact disk read-only memory (CD-ROM), an optical storage device, a magnetic storage device, or any suitable combination of the above.

Basic principles of this disclosure are described above in combination with specific embodiments. However, note that advantages, superiorities, effects, etc., mentioned in this disclosure are merely examples but are not for limitation, and it cannot be considered that these advantages, superiorities, effects, etc., are necessary for each embodiment of this disclosure. Moreover, specific details disclosed above are merely for examples and for ease of understanding, rather than limitations. The details described above do not limit that this disclosure must be implemented by using the foregoing specific details.

A person skilled in the art may make various modifications and variations to this disclosure without departing from the spirit and the scope of this application. In this way, if these modifications and variations of this application fall within the scope of the claims and equivalent technologies of the claims of this disclosure, this disclosure also intends to include these modifications and variations.

## Claims

1. A circuit for performing functional safety test, **characterized in that** the circuit comprises:
a configurator (201), configured for generating configuration information for testing an integrated circuit to be tested, and outputting the configuration information;
a plurality of test data generators (202), coupled to the configurator (201), and configured for generating and outputting, based on the configuration information, a plurality of first test data corresponding respectively to the test data generators (202);
the integrated circuit to be tested (203), coupled to the plurality of test data generators (202), and configured for processing the plurality of first test data, to obtain and output a plurality of second test data; and
a first comparator (204), coupled to the integrated circuit to be tested (203), and configured for comparing consistency among the plurality of second test data, to obtain a first test result for the integrated circuit to be tested (203).

2. The circuit according to claim 1, wherein the test data generators (202) are respectively configured for:
in response to the configuration information comprising first sub-configuration information corresponding to a random data test, generating random test data; and
in response to the configuration information comprising second sub-configuration information corresponding to a preset data test, generating preset test data,
wherein the first test data comprise the random test data or the preset test data.

3. The circuit according to claim 1, wherein the integrated circuit to be tested (203) comprises:
a plurality of first data converting circuits (2031), configured for performing a first data conversion on the plurality of first test data, to obtain and output a plurality of first converted data;
an arithmetic logic circuit (2032), coupled to the plurality of first data converting circuits (2031), and configured for performing arithmetic operation on the plurality of first converted data, to obtain and output a plurality of arithmetic operation data; and
a second data converting circuit (2033), coupled to the arithmetic logic circuit (2032), and configured for performing a second data conversion on the plurality of arithmetic operation data, to obtain and output the plurality of second test data.

4. The circuit according to claim 3, wherein the arithmetic logic circuit (2032) comprises:
a first logic operation circuit (401), configured for performing a first logic operation on the plurality of first converted data, to obtain a plurality of first operated data; and
a second logic operation circuit (402), configured for performing a second logic operation on the plurality of first operated data, to obtain the plurality of arithmetic operation data.

5. The circuit according to claim 4, further comprising:
a second comparator (205), coupled to the first logic operation circuit (401), and configured for comparing consistency among the plurality of first operated data, to obtain a second test result for the integrated circuit to be tested (203).

6. The circuit according to claim 5, wherein the second comparator (205) is configured for:
in response to the first test data being preset test data, determining expected data corresponding to the preset test data, and comparing consistency between the first operated data and the expected data, to obtain the second test result; or
in response to the first test data being random test data, comparing the consistency among the plurality of first operated data, to obtain the second test result.

7. The circuit according to claim 3, wherein the integrated circuit to be tested (203) further comprises:
a pipelining register unit (2034), coupled to the arithmetic logic circuit (2032) and the second data converting circuit (2033), respectively, and configured for temporarily storing the plurality of arithmetic operation data, and outputting the plurality of arithmetic operation data temporarily stored, wherein
the second data converting circuit (2033) is configured for performing the second data conversion on the plurality of arithmetic operation data temporarily stored, to obtain and output the plurality of second test data.

8. A method for performing functional safety test on an integrated circuit, **characterized in that** the method comprises:
generating (701), by a configurator, configuration information for testing an integrated circuit to be tested;
generating (702), by a plurality of test data generators based on the configuration information, a plurality of first test data corresponding respectively to the test data generators;
processing (703), by the integrated circuit to be tested, the plurality of first test data, to obtain a plurality of second test data; and
comparing (704), by a first comparator, consistency among the plurality of second test data, to obtain a first test result for the integrated circuit to be tested.

9. The method according to claim 8, wherein the processing (703), by the integrated circuit to be tested, the plurality of first test data, to obtain a plurality of second test data comprises:
performing (7031), by the plurality of first data converting circuits, a first data conversion on the plurality of first test data, to obtain and output a plurality of first converted data;
performing (7032), by the arithmetic logic circuit, arithmetic operation on the plurality of first converted data, to obtain and output a plurality of arithmetic operation data;
performing (7033), by the second data converting circuit, a second data conversion on the plurality of arithmetic operation data, to obtain and output the plurality of second test data.

10. The method according to claim 9, wherein the performing (7032), by the arithmetic logic circuit, arithmetic operation on the plurality of first converted data, to obtain and output a plurality of arithmetic operation data comprises:
performing (801), by the first logic operation circuit, a first logic operation on the plurality of first converted data, to obtain a plurality of first operated data;
performing (802), by the second logic operation circuit, second logic operation processing on the plurality of first operated data, to obtain the plurality of arithmetic operation data.

11. The method according to claim 10, further comprising:
comparing (803), by the second comparator, consistency among the plurality of first operated data, to obtain a second test result for the integrated circuit to be tested.

12. The method according to claim 11, wherein the comparing (803), by the second comparator, consistency among the plurality of first operated data, to obtain a second test result for the integrated circuit to be tested further comprising:
in response to the first test data being preset test data, determining, by the second comparator, expected data corresponding to the preset test data, and comparing consistency between the first operated data and the expected data, to obtain the second test result; or in response to the first test data being random test data, comparing, by the second comparator, the consistency among the plurality of first operated data, to obtain the second test result.

13. A neural processing unit, **characterized in that** the neural processing unit comprises the at least one circuit for performing functional safety test according to any one of claims 1 to 7.

14. An electronic device, **characterized in that** the electronic device comprises:
a memory (1202), configured for storing processor-executable instructions; and
a processor (1201), configured for reading the processor-executable instructions from the memory (1202), and executing the processor-executable instructions to implement the method for performing functional safety test on an integrated circuit according to claim 8.

15. A computer readable storage medium, storing a computer program, when executed by a processor, causes the processor to implement the method for performing functional safety test on an integrated circuit according to claim 8.
